# EUROPÄISCHE PATENTSCHRIFT

(11) **EP 1 527 662 B1**
(45) Veröffentlichungstag und Bekanntmachung des Hinweises auf die Patenterteilung: **25.01.2006**
(21) Anmeldenummer: 03790659.1
(22) Anmeldetag: 30.07.2003
(51) Int. Cl.: H05K 13/04

(54) **VORRICHTUNG ZUM SELEKTIVEN BEWEGEN VON HALTEVORRICHTUNGEN UND BEST CKKOPF ZUM TRANSPORTIEREN VON BAUELEMENTEN**
DEVICE FOR SELECTIVELY DISPLACING HOLDING DEVICES AND FITTING HEAD FOR TRANSPORTING COMPONENTS
DISPOSITIF DE DEPLACEMENT SELECTIF DE DISPOSITIFS DE RETENUE ET TETE D'INSERTION POUR LE TRANSPORT DE COMPOSANTS

(30) Priorität: 09.08.2002 DE 10236626
(43) Veröffentlichungstag der Anmeldung: 04.05.2005
(73) Patentinhaber: SIEMENS AKTIENGESELLSCHAFT, 80333 München (DE)
(72) Erfinder: BURGER, Stefan, 81379 München (DE); CONRAD, Robert, 82054 Sauerlach (DE); STANZL, Harald, 81476 München (DE)
(86) Internationale Anmeldenummer: PCT/DE2003/002562
(87) Internationale Veröffentlichungsnummer: WO 2004/021757

(56) Entgegenhaltungen:
- US-A- 5 743 001
- US-B1- 6 247 226

## Beschreibung

Die Erfindung betrifft eine Vorrichtung zum selektiven Bewegen von zumindest zwei Haltevorrichtungen, insbesondere Haltevorrichtungen für Bauelemente, welche im Rahmen eines Bestückprozesses von einer Entnahmeposition zu einer Aufsetzposition transportiert werden. Die Erfindung betrifft ferner einen Bestückkopf zum Transportieren von einer Mehrzahl von Bauelementen von einer Abholposition hin zu einer Aufsetzposition.

Die automatische Bestückung von Substraten bzw. Leiterplatten mit Bauelementen erfolgt heutzutage üblicherweise mittels sog. Bestückautomaten. Dabei werden Bauelemente von einer Abholposition einer Bauelementzuführeinrichtung mittels eines Bestückkopfes zu einer Aufsetzposition transportiert. Um eine hohe Bestückleistung zu erreichen, weisen die Bestückköpfe eine Mehrzahl von Haltevorrichtungen auf, mittels welchen gleichzeitig eine Mehrzahl von Bauelementen auf dem Transportweg zwischen der Bauelementzuführeinrichtung und der Aufsetzposition gehalten werden. Als Haltevorrichtungen haben sich insbesondere sog. Saugpipetten bewährt, welche die zu transportierenden Bauelemente mittels eines angelegten Unterdruckes zuverlässig halten können.

Insbesondere bei Bestückköpfen mit einer Mehrzahl von Haltevorrichtungen ist es aufgrund der Massenträgheit des gesamten Bestückkopfes vorteilhaft, wenn beim Aufsetzvorgang eines einzelnen Bauelementes nicht der gesamte Bestückkopf in Richtung des zu bestückenden Substrats bewegt wird, sondern wenn nur diejenige Haltevorrichtung bewegt wird, welche das entsprechende Bauelement hält.

Aus der US 5,743,001 ist ein Bestücksystem bekannt, welches eine Mehrzahl von Haltevorrichtungen aufweist, die in einer oder in zwei nebeneinanderliegenden Reihen angeordnet sind. Jede Haltevorrichtung ist unabhängig von den anderen Haltevorrichtungen um ihre Längsachse drehbar. Außerdem ist jede Haltevorrichtung unabhängig von den anderen Haltevorrichtungen entlang einer z-Achse bewegbar, welche die Richtung darstellt, entlang welcher der Aufsetzvorgang der Bauelemente erfolgt.

Aus der WO 96/12394 ist ein Bestückkopf für einen Bestückautomaten bekannt, welcher eine Mehrzahl von Haltevorrichtungen aufweist, die mittels eines gemeinsamen Antriebs entlang einer z-Richtung individuell bewegbar sind. Dies wird dadurch erreicht, dass die einzelnen Haltevorrichtungen bei Bedarf mit dem gemeinsamen Antrieb mechanisch koppelbar sind, so dass bei entsprechender Bewegung des Antriebs selektiv diejenigen Haltevorrichtungen entlang der z-Achse bewegt werden, welche gerade mit dem Antrieb gekoppelt sind. Dies hat den Nachteil, dass beim Ankoppeln bzw. beim Abkoppeln die Haltevorrichtungen jeweils ruckartig bewegt werden. Bei einem derartigen Prellen der Haltevorrichtungen besteht die Gefahr, dass von der Haltevorrichtung gehaltene Bauelemente herunterfallen oder verrutschen, so dass das jeweilige Bauelement für den Bestückvorgang verloren ist oder zu einer fehlerhaften Bestückung einer Leiterplatte führt.

Der Erfindung liegt die Aufgabe zugrunde, eine Vorrichtung zum selektiven Bewegen von zumindest zwei Haltevorrichtungen zu schaffen, bei welcher eine weitgehend prellfreie Bewegung gewährleistet ist. Der Erfindung liegt ferner die Aufgabe zugrunde, einen Bestückkopf zum Transportieren von einer Mehrzahl von Bauelementen zu schaffen, bei welchem eine Mehrzahl von Haltevorrichtungen individuell bewegbar sind und die Bewegungen ebenfalls jeweils weitgehend prellfrei erfolgen.

Die der Erfindung zugrundeliegende erste Aufgabe wird gelöst durch eine Vorrichtung mit den Merkmalen des unabhängigen Anspruchs 1. Der Erfindung liegt die Erkenntnis zugrunde, dass bei Verwendung eines zentralen Antriebs, mittels welchem ein sog. Hubelement entlang der z-Achse bewegt wird, einzelne Haltevorrichtungen selektiv an die vorgegebene Bewegung des Hubelements nahezu prellfrei angekoppelt werden können, wenn für jede Haltevorrichtung ein Elektromagnet vorgesehen ist, welcher bei entsprechendem Stromfluss eine magnetische Anziehung an das entlang der z-Achse bewegte Hubelement bewirkt. Die ausschließlich magnetische Ankopplung der einzelnen Haltevorrichtungen an den zentralen z-Antrieb, bei welcher keine Relativbewegung zwischen dem stromdurchflossenen Elektromagneten und dem Hubelement erforderlich ist, kann sehr schnell und bei geringem Verschleiß erfolgen. Ein weiterer Vorteil der Erfindung besteht darin, dass eine erfindungsgemäße ausschließlich magnetische Koppeleinheit sehr platzsparend realisiert werden kann.

Die Vorrichtung gemäß Anspruch 2 hat den Vorteil, dass eine magnetische Ankopplung zwischen Elektromagnet und Hubelement dadurch gewährleistet ist, dass ausschließlich der mit der Haltevorrichtung verbundene Elektromagnet und nicht ein mit dem Hubelement fest verbundener Elektromagnet mit einem Stromfluss belegt wird. Das resultierende Magnetfeld sorgt dann für eine magnetische Wechselwirkung zwischen dem Elektromagneten und dem magnetischen Material des Hubelements. Eine Magnetfelderzeugung mittels stromdurchflossener Elektromagneten ist damit auf Seiten des Hubelements nicht erforderlich.

Gemäß Anspruch 4 kann ein Hub- oder Haltemechanismus eingesetzt werden, um die Haltevorrichtung bevorzugt in einer Ausgangslage zu halten. Ein Hubmechanismus kann durch eine Feder oder einem Hubzylinder realisiert werden. In diesem Fall erfolgt bei einer Aktivierung des entsprechenden Elektromagneten eine Bewegung der Haltevorrichtung entgegen der mit dem Hubmechanismus auf die Haltevorrichtung ausgeübten Kraft. Ein Haltemechanismus kann durch eine seitliche Klemmung, beispielsweise mittels eines Piezoelements oder durch den Einsatz eines Haftmagneten realisiert werden. In diesem Fall erfolgt nach einem Lösen des Haltemechanismusses die gemeinsame Bewegung von Hubelement und Haltevorrichtung abgesehen von der Schwerkraft und evtl. vorhandenen Reibungskräften weitgehend kräftefrei.

Die Weiterbildung gemäß Anspruch 5 hat den Vorteil, dass zwischen dem gemeinsamen z-Antrieb und dem Hubelement keine weiteren mechanischen Zwischenglieder, wie beispielsweise Kardanwellen, Umlenkrollen, Zahnräder oder Getriebe geschaltet werden müssen. Die Verwendung eines Linearmotors als gemeinsamen z-Antrieb hat den Vorteil, dass der Antrieb weitgehend verschleißfrei und damit wartungsarm ist. Die Verwendung eines Spindelantriebs, eines Riemenantriebs, eines Piezomotors und eines pneumatischer Antriebs hat den Vorteil, dass der gemeinsame Antrieb leicht und mit geringem Platzbedarf realisiert werden kann.

Ein besonderes ruckfreier Bewegungsverlauf des Hubelements und somit auch ein besonderes ruckfreier Bewegungsverlauf der magnetisch angekoppelten Haltevorrichtungen wird gemäß Anspruch 6 dadurch erzielt, dass der Anfahr- und/oder der Abbremsvorgang des Linearmotors durch eine sinusförmige Ansteuerung des Linearmotors erzeugt wird. Alternativ zu einer sinusförmigen Ansteuerung kann selbstverständlich jede andere Ansteuerung des Linearmotors verwendet werden, die zu einem stetigen Bewegungsverlauf führt.

Gemäß Anspruch 7 sorgen zusätzliche Dämpfungselemente zuverlässig dafür, dass ein Prellen der Haltevorrichtung beim Ankoppelvorgang des Elektromagneten an das Hubelement weitegehend verhindert wird.

Gemäß Anspruch 10 weist die Haltevorrichtung bevorzugt in ihrem oberen Abschnitt eine Verbindungsstange auf, welche relativ zu dem Grundkörper verdrehsicher gelagert ist.

Die verdrehsichere Lagerung der Verbindungsstange schafft die Voraussetzung dafür, dass nach Anspruch 11 eine Dreheinrichtung für jede Haltevorrichtung vorgesehen sein kann, mittels welcher derjenige Teil der Haltevorrichtung um die z-Achse verdrehbar ist, an welchem die Bauelemente gehalten werden. Durch eine Verdrehung der Bauelemente um die z-Achse kann beispielsweise eine Winkelkorrektur vorgenommen werden. Eine derartige Winkelkorrektur ist häufig erforderlich, weil die einzelnen Bauelemente mit leicht unterschiedlichen Winkellagen vor dem Aufnehmen der Bauelemente in der Entnahmeposition liegen und außerdem in der Regel mit unterschiedlichen Setzpositionen auf die Leiterplatte aufgesetzt werden müssen. Aus diesem Grund müssen die zu bestückenden Bauelemente nach dem Aufnehmen und vor dem Aufsetzen um einen bestimmten Winkel um die z-Achse verdreht werden. Nur so kann eine zuverlässige Kontaktierung der Bauelementanschlüsse mit den auf der Leiterplatte vorgesehenen Kontaktflächen gewährleistet werden.

Die weitere der Erfindung zugrundeliegende Aufgabe wird gelöst durch einen Bestückkopf zum Transportieren von einer Mehrzahl von Bauelementen mit den Merkmalen des unabhängigen Anspruchs 13. Der erfindungsgemäße Bestückkopf beruht auf der Erkenntnis, dass eine Mehrzahl von Haltevorrichtungen, welche jeweils entlang einer z-Achse verschiebbar gelagert sind, mittels eines zentral gesteuerten z-Antriebs entlang der z-Achse bewegt werden können, wobei durch einen magnetischen Kopplungsmechanismus jede einzelne Haltevorrichtung bei einem Stromfluss durch den entsprechenden Elektromagneten selektiv an eine vorgegebene Bewegung des z-Antriebs angekoppelt werden kann. Der erfindungsgemäße Bestückkopf hat den Vorteil, dass die Anzahl an notwendigen z-Antrieben im Vergleich zu Bestückköpfen, bei denen für jede Haltevorrichtung ein individueller z-Antrieb vorgesehen ist, erheblich reduziert ist.

Auf diese Weise kann abhängig von der Anzahl der Haltevorrichtungen eine erhebliche Gewichtsersparnis und somit eine Steigerung der resultierenden Bestückleistung erreicht werden. Gegenüber bekannten Bestückköpfen mit ebenfalls einem zentralen z-Antrieb und mit einer mechanischen Ankopplung der einzelnen Haltevorrichtungen an den z-Antrieb hat der erfindungsgemäße Bestückkopf den Vorteil, dass die Bewegung der Haltevorrichtungen weitgehend prellfrei erfolgt, so dass ein Herunterfallen oder ein Verrutschen von Bauelementen vermieden und somit ein zuverlässiger Transport der Bauelemente gewährleistet wird. Gegenüber einem herkömmlichen sog. Revolverkopf, bei welchem eine Mehrzahl von Haltevorrichtungen sternförmig um eine Rotationsachse herum angeordnet sind, hat der erfindungsgemäße Bestückkopf den Vorteil, dass mit einer einzigen Kamera sämtliche Bauelemente, die sich an den Haltevorrichtungen befinden, erfassbar sind. Somit entfällt das bei Revolverköpfen erforderliche Mitführen einer Kamera, mittels welcher die Lage und die Art der transportierten Bauelemente erfasst wird, so dass eine zusätzliche Gewichtsersparnis erreicht und damit die Bestückleistung zusätzlich erhöht wird. Gegenüber Revolverköpfen haben erfindungsgemäße Bestückköpfe den Vorteil, dass eine Mehrzahl von Bauelementen nacheinander aufgenommen bzw. abgesetzt werden können, ohne dass dafür eine Rotation der Mehrzahl von Haltevorrichtungen um eine Rotationsachse erforderlich ist. Auf diese Weise werden die auf die Bauelemente wirkenden Fliehkräfte reduziert, so dass der erfindungsgemäße Bestückkopf im Vergleich zu einem Revolverkopf mit einer höheren Beschleunigung von der Entnahmeposition hin zu der Aufsetzposition bewegt werden kann, ohne dass dabei die gehaltenen Bauelemente verloren gehen. Somit kann mit einem erfindungsgemäßen Bestückkopf eine höhere Bestückleistung erzielt werden.

Weitere Vorteile und Merkmale der vorliegenden Erfindung ergeben sich aus der folgenden beispielhaften Beschreibung derzeit bevorzugter Ausführungsformen, in welchen gilt:
- Figur 1: zeigt in einer schematischen Darstellung eine Vorrichtung zum selektiven Bewegen von zwei Haltevorrichtungen.
- Figur 2: zeigt eine Querschnittsansicht eines Bestückkopfes, bei welchem 4x4 Haltevorrichtungen in Form einer quadratischen Matrix angeordnet sind.
- Figur 3: zeigt in einer vergrößerten Darstellung eine Haltevorrichtung des in Figur 2 dargestellten Bestückkopfes.
- Figur 4: zeigt eine Ansicht von unten des in Figur 2 dargestellten Bestückkopfes.

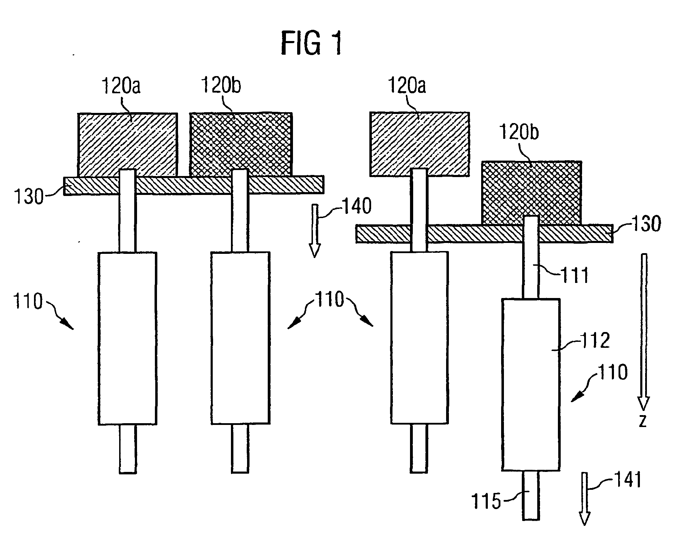

Figur 1 zeigt eine Vorrichtung zum selektiven Bewegen von zwei Haltevorrichtungen 110, welche mittels einer Hubplatte 130 entlang der z-Richtung bewegt werden können. Jede der beiden Haltevorrichtungen 110 ist mit einem Elektromagneten 120a bzw. 120b fest verbunden. Die unterschiedliche Schraffierung der beiden Elektromagneten 120a und 120b in Figur 1 soll verdeutlichen, dass der Elektromagnet 120a nicht stromdurchflossen ist und dass der Elektromagnet 120b stromdurchflossen ist. Damit ergibt sich, dass nur der Elektromagnet 120b ein magnetisches Feld erzeugt und somit mit der Hubplatte 130, welche aus Gründen der Gewichtsersparnis teilweise aus einem ferromagnetischen Material besteht, fest verbunden ist. Wird die Hubplatte 130, wie durch den Pfeil 140 verdeutlicht, entlang der z-Achse nach unten bewegt, dann bewegt sich auch der Elektromagnet 120b und die mit dem Elektromagneten 120b verbundene Haltevorrichtung 110, wie durch den Pfeil 141 verdeutlicht, entlang der z-Richtung nach unten. Die mit dem Elektromagneten 120a verbundene Haltevorrichtung 110 wird durch in Figur 1 nicht dargestellte Hubmechanismen in der oberen Position gehalten.

Jede Haltevorrichtung 110 weist eine Verbindungsstange 111 sowie eine Pipettenhalterung 115 auf. Über die Pipettenhalterung 115 kann ein Unterdruck an eine nicht dargestellte Pipette angelegt werden, so dass an jeder Haltevorrichtung 110 jeweils ein Bauelement gehalten werden kann. Zwischen der Verbindungsstange 111 und der Pipettenhalterung 115 ist für jede Haltevorrichtung 110 eine Dreheinrichtung 112 vorgesehen, mittels welcher die Pipettenhalterung 115 relativ zu der Verbindungsstange um die z-Achse verdreht werden kann. Somit kann ein von der Haltevorrichtung 110 gehaltenes Bauelement während des Transportes von einer Entnahmeposition zu einer Aufsetzposition auf einem Substrat um die z-Achse verdreht werden.

Es wird darauf hingewiesen, dass ein eventuell verbliebenes leichtes Prellen zwischen Hubplatte 130 und Elektromagnet 120b, welches beim Einschalten eines durch den Elektromagneten 120b fließenden Stromes erzeugt wird, durch die Verwendung von Dämpfungselementen wirksam verhindert wird. Ein Dämpfungselement kann beispielsweise eine auf dem Hubelement fixierte Elastomerplatte sein, auf welcher eine ferromagnetische Haftscheibe angebracht ist, an welche der Elektromagnet 120b ohne Luftspalt ankoppeln kann. Die Vermeidung eines Luftspaltes hat den Vorteil, dass die Haltevorrichtung 110 bei entsprechender Aktivierung des Elektromagneten 120b mit einer größeren Kraftwirkung an die Hubplatte 130 angekoppelt ist.

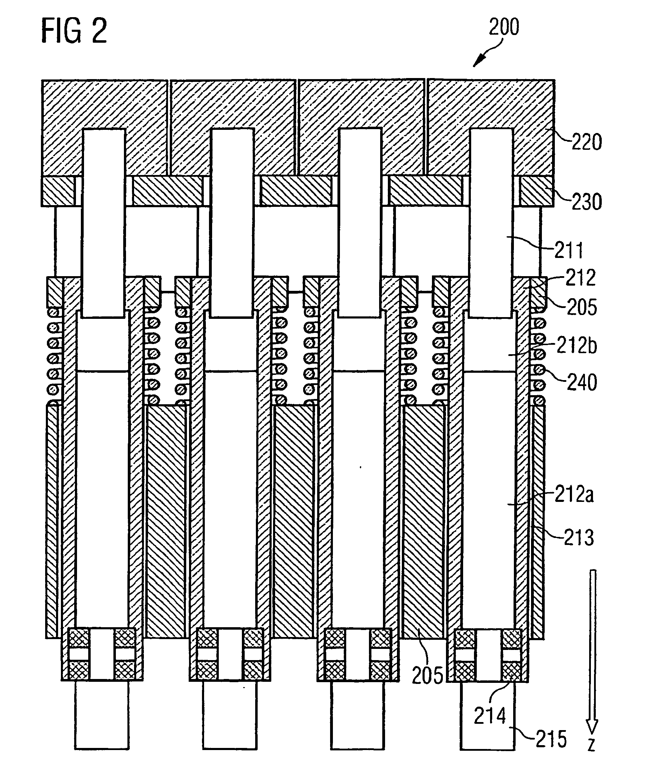

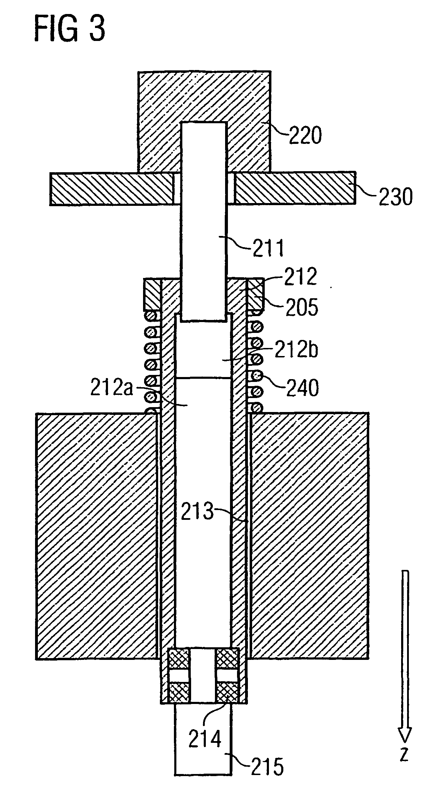

Im folgenden wird ein Bestückkopf gemäß einem Ausführungsbeispiel der Erfindung anhand der Figuren 2, 3 und 4 beschrieben. Dabei werden gleiche Bezugszeichen für gleiche Bauteile verwendet. Figur 2 zeigt eine Querschnittsansicht eines Bestückkopfes gemäß einem Ausführungsbeispiel der Erfindung, bei welchem Bestückkopf insgesamt 16 Haltevorrichtungen in Form einer 4x4-Matrix angeordnet sind. Figur 3 zeigt in einer vergrößerten Darstellung eine der in Figur 2 dargestellten Haltevorrichtungen. Der Bestückkopf 200 weist einen Grundkörper 205 auf. Relativ zu dem Grundkörper 205 sind Haltevorrichtungen entlang der z-Achse bewegbar gelagert. Jede Haltevorrichtung weist eine Verbindungsstange 211, eine Dreheinrichtung 212, eine Pipettenhalterung 215 sowie einen Elektromagneten 220 auf. Die Verbindungsstangen 211 sind relativ zu dem Grundkörper 205 entlang der z-Achse verschiebbar gelagert, wobei bei einer Verschiebung nach unten eine Rückholfeder 240, welche zwischen einem Klemmring 206 und dem Grundkörper 205 eingespannt ist, komprimiert wird. Als Lagerungen kommen insbesondere verschleißarme Luftlagerungen oder Linearkugellager in Frage. Auf jeden Fall müssen die Lagerungen der Verbindungsstangen 211 relativ zur z-Achse verdrehsicher sein. Gemäß dem hier beschriebenen Ausführungsbeispiel der Erfindung sind die Dreheinrichtungen 212 in dem Grundkörper 205 in einem Luftlager 213 gelagert, welches bei einem Absenken der Hubplatte 230 eine präzise Führung der Haltevorrichtungen gewährleistet.

Die Dreheinrichtungen 212 weisen jeweils einen Drehantrieb 212a und eine Winkelmesseinrichtung 212b auf. Der Drehantrieb 212a dient dazu, die Pipettenhalterung 215 relativ zu der Verbindungsstange 211 um die z-Achse herum zu verdrehen. Somit kann ein an einer nicht dargestellten Pipette gehaltenes Bauelement relativ zu dem Grundkörper 205 um die z-Achse verdreht werden. Die Winkelmesseinrichtung 212b dient dazu, den mittels des Drehantriebs 212a erzeugten Drehwinkel eines Bauelements präzise zu messen. Auf diese Weise kann eine genaue Winkelkorrektur eines Bauelements während des Transportes des Bauelements von einer Entnahmeposition hin zu einer Aufsetzposition vorgenommen werden.

Das für das Halten von Bauelementen erforderliche Vakuum kann bevorzugt auf zwei Arten an die Pipettenhalterung 215 zugeführt werden:
(a) Das Vakuum wird an einen nicht dargestellten, in der Dreheinrichtung 212 ausgebildeten Saugkanal angelegt und auf die Pipettenhalterung 215 übertragen. Dabei wird das Vakuum jeweils bevorzugt mittels eines flexiblen Schlauches, welcher in dem Bereich zwischen der Dreheinrichtung 212 und der Hubplatte 230 an die Dreheinrichtung 212 herangeführt wird, auf den Saugkanal übertragen. Zur Vermeidung von Vakuumverlusten befindet sich zwischen dem Drehantrieb 212a und der Winkelmesseinrichtung 212b eine Dichtung. Zwischen der Dreheinrichtung 212 und der Pipettenhalterung 215 befindet sich eine weitgehend vakuumdichte Halterung 214.
(b) Das für die Aufnahme von Bauelementen erforderliche Vakuum wird über nicht dargestellte Schläuche seitlich an die Halterung 214 herangeführt und auf die Pipettenhalterung 215 übertragen.

Der Bestückkopf 200 weist ferner eine Hubplatte 230 auf, welche zumindest teilweise aus einem ferromagnetischen Material hergestellt ist oder an welcher ferromagnetische Haftscheiben indirekt über Dämpfungselements befestigt sind. Auf diese Weise können an die Hubplatte 230 direkt oder indirekt diejenigen Elektromagneten 220 fest ankoppeln, welche bei einem entsprechenden Stromfluss ein Magnetfeld erzeugen, das die Hubplatte 230 an den Elektromagneten 220 anzieht.

Jeder Haltevorrichtung ist ferner eine Rückholfeder 240 zugeordnet, welche im Ausgangszustand die Haltevorrichtung in einer oberen Position hält. Bei einer Bewegung der Hubplatte 230 entlang der z-Achse nach unten und einem Stromfluss durch den Elektromagneten 220 wird die mit dem Elektromagneten 220 verbundene Haltevorrichtung entgegen der Federkraft der Rückholfeder 240 nach unten bewegt. Bei einer nachfolgenden Bewegung der Hubplatte entlang der z-Richtung nach oben in die Ausgangsstellung der Hubplatte 230 sorgt die Rückholfeder 240 dafür, dass die entsprechende Haltevorrichtung auch dann nach oben bewegt wird, wenn der Elektromagnet nicht mehr von Strom durchflossen ist.

Es wird darauf hingewiesen, dass die Rückholfeder 240 auch durch sonstige Hub- oder Haltemechanismen ersetzt werden kann, welche dafür sorgen, dass zumindest bei nicht vorhandenen Aktivierung des entsprechenden Elektromagneten die dem Elektromagneten zugeordnete Haltevorrichtung in der oberen Position gehalten wird.

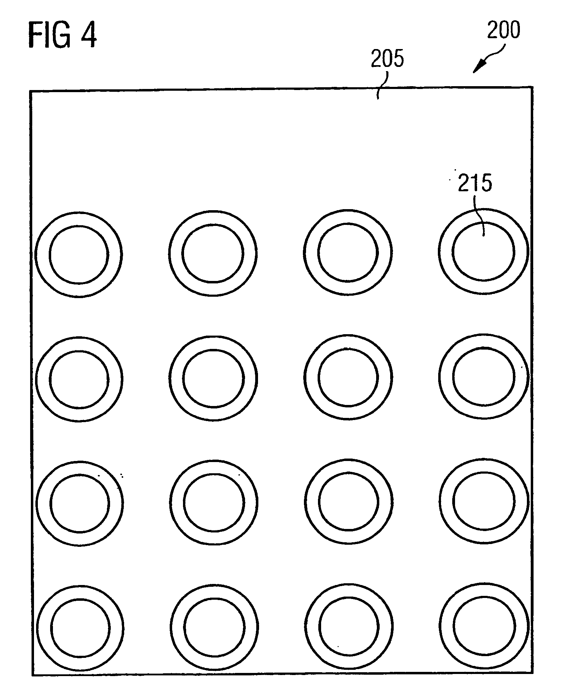

Figur 4 zeigt den anhand der Figuren 2 und 3 beschriebenen Bestückkopf 200 in einer schematischen Darstellung von unten. In dieser Ansicht ist der Grundkörper 205 zu erkennen, in welchem insgesamt 16 Haltevorrichtung in Form einer 4x4-Matrix angeordnet sind. Von den 16 Haltevorrichtungen ist in der in Figur 4 dargestellten Ansicht jeweils die Pipettenhalterung 215 zu erkennen, auf welche die nicht dargestellten Saugpipetten aufsteckbar sind.

Zusammenfassend schafft die Erfindung eine Vorrichtung zum selektiven Bewegen von zumindest zwei Haltevorrichtungen 110, welche mittels eines zentralen z-Antriebs und durch eine selektive magnetische Ankopplung an ein gemeinsames Hubelement 130 entlang einer z-Achse individuell bewegbar sind. Durch die ausschließlich magnetische Ankopplung der Haltevorrichtungen an das Hubelement 130 kann bei entsprechender ruckfreier Bewegung des Hubelements 130 eine weitgehend prellfreie Bewegung der angekoppelten Haltevorrichtungen 110 gewährleistet werden. Dies ist insbesondere bei dem Transport von Bauelementen vorteilhaft, da durch prellfreie Bewegungen der Haltevorrichtungen 110 ein Herunterfallen oder Verrutschen von Bauelementen verhindert wird. Die Erfindung schafft ferner einen Bestückkopf 200 zum Transportieren von einer Mehrzahl von Bauelementen, bei dem die Haltevorrichtungen 110 entlang einer Linie oder an den Gitterpunkten eines zweidimensionalen Rasters angeordnet sind. Die Haltevorrichtungen 110 sind an die Bewegung eines gemeinsamen Hubelements 130 individuell ankoppelbar.

## Patentansprüche

1. Vorrichtung zum selektiven Bewegen von zumindest zwei Haltevorrichtungen (110), insbesondere Haltevorrichtungen (110) für Bauelemente, welche im Rahmen eines Bestückprozesses von einer Entnahmeposition zu einer Aufsetzposition transportiert werden, mit
• einem Grundkörper (205),
• einer ersten Haltevorrichtung (110),
- welche relativ zu dem Grundkörper (205) entlang einer z-Achse verschiebbar gelagert ist,
- welche durch einen ersten Mechanismus (240) bevorzugt in einer Ausgangslage gehalten wird und
- an welcher ein erster Elektromagnet (220) befestigt ist,
• einer zweiten Haltevorrichtung (110),
- welche relativ zu dem Grundkörper (205) entlang der z-Achse verschiebbar gelagert ist,
- welche durch einen zweiten Mechanismus (240) bevorzugt in einer Ausgangslage gehalten wird und
- an welcher ein zweiter Elektromagnet (220) befestigt ist, und
• einem Hubelement (130), welches mittels eines Antriebs entlang der z-Achse bewegbar ist und an welches die beiden Elektromagneten (220) bei entsprechender Aktivierung magnetisch ankoppelbar sind, so dass die dem aktivierten Elektromagneten (120b) zugeordnete Haltevorrichtung (110) gemeinsam mit dem Hubelement (130) entlang der z-Achse verschoben wird.

2. Vorrichtung gemäß Anspruch 1, bei der das Hubelement (130) eine Platte aus einem ferromagnetischen Material aufweist.

3. Vorrichtung gemäß einem der Ansprüche 1 bis 2, derart ausgebildet, dass die Haltevorrichtungen (110)
• im Falle von nicht aktivierten Elektromagneten (120a) von den Mechanismen (240) in einer oberen Position gehalten werden und
• im Falle einer Aktivierung der entsprechenden Elektromagneten (120b) bei einem Absenken des Hubelements (130) entlang der z-Achse nach unten bewegt werden.

4. Vorrichtung gemäß einem der Ansprüche 1 bis 3, bei der der Mechanismus ein Hubmechanismus und/oder ein Haltemechanismus ist.

5. Vorrichtung gemäß einem der Ansprüche 1 bis 4, bei der der Antrieb ein Linearmotor, ein Spindelantrieb, ein Riemenantrieb, ein Piezomotor und/oder ein pneumatischer Antrieb ist.

6. Vorrichtung gemäß einem der Ansprüche 1 bis 5, bei der der Antrieb derart ausgebildet ist und/oder der Antrieb derart angesteuert wird, dass der Bewegungsverlauf des Hubelements (130) ausschließlich stetige Beschleunigungsverläufe aufweist.

7. Vorrichtung gemäß einem der Ansprüche 1 bis 6, bei der für das Hubelement (130) zusätzlich ein Dämpfungselement vorgesehen ist, mittels welchem ein Prellen der Haltevorrichtung (110) beim Ankoppelvorgang zumindest gemindert wird.

8. Vorrichtung gemäß Anspruch 7, bei der das Dämpfungselement eine Elastomerplatte und/oder ein gedämpftes Federelement ist.

9. Vorrichtung gemäß einem der Ansprüche 1 bis 8, bei der die Haltevorrichtung (110) eine entlang der z-Achse angeordnete Pipettenhalterung (215) und eine an der Pipettenhalterung (215) angebrachte Saugpipette aufweist, an welche ein zu transportierendes Bauelement bei Anlegen eines Unterdrucks ansaugbar ist.

10. Vorrichtung gemäß Anspruch 9, bei der die Haltevorrichtung (110) zusätzlich eine Verbindungsstange (211) aufweist, welche relativ zu dem Grundkörper (205) derart gelagert ist, dass ein Verdrehen der Verbindungsstange (211) um die z-Achse verhindert wird.

11. Vorrichtung gemäß Anspruch 10, bei der die Haltevorrichtung (110) zusätzlich eine zwischen der Verbindungsstange (211) und der Pipettenhalterung (215) angeordnete Dreheinrichtung (212) aufweist, mittels welcher die Saugpipette relativ zu dem Grundkörper (205) um z-Achse verdrehbar ist.

12. Vorrichtung gemäß Anspruch 11, bei der für die Dreheinrichtung (212) zusätzlich eine Messeinrichtung (212b) vorgesehen ist, mittels welcher der Drehwinkel der Saugpipette relativ zu dem Grundkörper (205) erfassbar ist.

13. Bestückkopf zum Transportieren von einer Mehrzahl von Bauelementen von jeweils einer Abholposition zu jeweils einer Aufsetzposition, mit einer Vorrichtung gemäß einem der Ansprüche 1 bis 10, welche eine Mehrzahl von Haltevorrichtungen (110) aufweist, die entlang einer Reihe oder an den Gitterpunkten eines zweidimensionalen Rasters angeordnet sind.

14. Bestückkopf gemäß Anspruch 13, bei dem das zweidimensionale Raster eine rechtwinklige Matrix ist.

15. Bestückkopf gemäß Anspruch 14, bei dem die Matrix zwei oder mehrere Reihen und zwei oder mehrere Spalten aufweist.

## Claims

1. Device for selectively displacing at least two holding devices (110), in particular holding devices (110) for components which are transported from a retrieval position to a placement position as part of an assembly process, having
• a basic body (205),
• a first holding device (110),
- which, relative to the basic body (205), is so mounted as to be displaceable along a z-axis,
- which is held by a first mechanism (240) preferably in a home position and
- to which is secured a first electromagnet (220),
• a second holding device (110),
- which, relative to the basic body (205), is so mounted as to be displaceable along the z-axis,
- which is held by a second mechanism (240) preferably in a home position and
- to which is secured a second electromagnet (220),
• a lifting element (130), which is movable along the z-axis by means of a drive and to which the two electromagnets (220) can be magnetically coupled when appropriately activated so that the holding device (110) assigned to the activated electromagnet (120b) is displaced along the z-axis together with the lifting element (130).

2. Device according to claim 1, wherein the lifting element (130) has a plate made from a ferromagnetic material.

3. Device according to one of claims 1 to 2, designed so that the holding devices (110),
• if the electromagnets are not activated (120a), are held by the mechanisms (240) in an upper position and,
• if the appropriate electromagnets are activated (120b), are moved downwards along the z-axis when the lifting element (130) is lowered.

4. Device according to one of claims 1 to 3, wherein the mechanism is a lifting mechanism and/or a holding mechanism.

5. Device according to one of claims 1 to 4, wherein the drive is a linear motor, a spindle drive, a belt drive, a piezo motor and/or a pneumatic drive.

6. Device according to one of claims 1 to 5, wherein the drive is designed in such a way and/or the drive is controlled in such a way that the movement pattern of the lifting element (130) has exclusively steady acceleration patterns.

7. Device according to one of claims 1 to 6, wherein there is additionally provided for the lifting element (130) a damping element, by means of which bouncing of the holding device (110) is at least reduced during the coupling process.

8. Device according to claim 7, wherein the damping element is an elastomer sheet and/or a damped spring element.

9. Device according to one of claims 1 to 8, wherein the holding device (110) has a pipette holder (215) arranged along the z-axis and has a suction pipette which is attached to the pipette holder (215) and onto which a component to be transported can be sucked when a negative pressure is applied.

10. Device according to claim 9, wherein the holding device (110) additionally has a connecting rod (211) mounted relative to the basic body (205) so as to prevent the connecting rod (211) from rotating about the z-axis.

11. Device according to claim 10, wherein the holding device (110) additionally has a rotation mechanism (212) which is arranged between the connecting rod (211) and the pipette holder (215) and by means of which the suction pipette can be rotated about the z-axis relative to the basic body (205).

12. Device according to claim 11, wherein there is additionally provided for the rotation mechanism (212) a measuring device (212b) by means of which the angle of rotation of the suction pipette relative to the basic body (205) can be detected.

13. Fitting head for transporting a plurality of components from a respective collection position to a respective placement position, with a device according to one of claims 1 to 10 having a plurality of holding devices (110) arranged in a row or at the grid points of a two-dimensional grid.

14. Fitting head according to claim 11, wherein the two-dimensional grid is a rectangular matrix.

15. Fitting head according to claim 12, wherein the matrix has two or more rows and two or more columns.

## Revendications

1. Dispositif pour déplacer sélectivement au moins deux dispositifs de maintien (110), en particulier des dispositifs de maintien (110) de composants qui sont transportés depuis une position de prélèvement jusque dans une position de placement au cours d'une opération de montage, et qui présente :
• un corps de base (205),
• un premier dispositif de maintien (110)
- monté de manière à pouvoir coulisser par rapport au corps de base (205) le long d'un axe z,
- maintenu de préférence dans une position initiale par un premier mécanisme (240) et
- auquel un premier électroaimant (220) est fixé,
• un deuxième dispositif de maintien (110)
- monté de manière à pouvoir coulisser par rapport au corps de base (205) le long de l'axe z,
- maintenu de préférence dans une position initiale par un deuxième mécanisme (240) et
- auquel un deuxième électroaimant (220) est fixé et
• un élément de levage 130 qui peut être déplacé le long de l'axe z au moyen d'un entraînement et auquel les deux électroaimants (220) peuvent être accouplés magnétiquement lorsqu'ils sont activés de manière appropriée de telle sorte que le dispositif de maintien (110) associé à l'électroaimant (120b) activé est déplacé le long de l'axe z en même temps que l'élément de levage (130).

2. Dispositif selon la revendication 1, dans lequel l'élément de levage (130) présente une plaque en un matériau ferromagnétique.

3. Dispositif selon l'une des revendications 1 ou 2, configuré de telle sorte que les dispositifs de maintien (110)
• sont maintenus dans une position haute par les mécanismes (240) lorsque les électroaimants (120a) ne sont pas activés, et
• sont déplacés vers le bas lorsque l'élément de levage (130) est abaissé le long de l'axe z lorsque les électroaimants (120b) correspondants sont activés.

4. Dispositif selon l'une des revendications 1 à 3, dans lequel le mécanisme est un mécanisme de levage et/ou un mécanisme de maintien.

5. Dispositif selon l'une des revendications 1 à 4, dans lequel l'entraînement est un moteur linéaire, un entraînement à broche filetée, un entraînement à courroie, un moteur piézoélectrique et/ou un entraînement pneumatique.

6. Dispositif selon l'une des revendications 1 à 5, dans lequel l'entraînement est configuré et/ou est commandé de telle sorte que le déroulement du déplacement de l'élément de levage (130) présente uniquement des courbes d'accélérations continues.

7. Dispositif selon l'une des revendications 1 à 6, dans lequel est prévu de plus un élément d'amortissement pour l'élément de levage (130) au moyen duquel un à-coup du dispositif de maintien (110) pendant l'opération d'accouplement est au moins diminué.

8. Dispositif selon la revendication 7, dans lequel l'élément d'amortissement est une plaque en élastomère et/ou un élément élastique amorti.

9. Dispositif selon l'une des revendications 1 à 8, dans lequel le dispositif de maintien (110) présente un porte-pipette (215) disposé le long de l'axe z et une pipette aspirante installée sur le porte-pipette (215) et sur laquelle un composant à transporter peut être aspiré en appliquant une dépression.

10. Dispositif selon la revendication 9, dans lequel le dispositif de maintien (110) présente de plus une tringle de liaison (211) qui est montée par rapport au corps de base (205) de manière à empêcher que la tringle de liaison (211) tourne autour de l'axe z.

11. Dispositif selon la revendication 10, dans lequel le dispositif de maintien (110) présente de plus un dispositif de rotation (212) disposé entre la tringle de liaison (211) et le porte-pipette (215), au moyen duquel la pipette aspirante peut être tournée autour de l'axe z par rapport au corps de base (205).

12. Dispositif selon la revendication 11, dans lequel est prévu de plus un dispositif de mesure (212b) pour le dispositif de rotation (212) au moyen duquel l'angle de rotation de la pipette aspirante peut être détectée par rapport au corps de base (205).

13. Tête de montage qui transporte une pluralité de composants depuis une position de prélèvement respective jusque dans une position de placement respective, qui présente un dispositif selon l'une des revendications 1 à 10 qui présente une pluralité de dispositifs de maintien (110) qui sont disposés en rangée ou aux points de croisement d'un treillis bidimensionnel.

14. Tête de montage selon la revendication 13, dans laquelle le treillis bidimensionnel est une matrice rectangulaire.

15. Tête de montage selon la revendication 14, dans laquelle la matrice présente deux ou plusieurs lignes et deux ou plusieurs colonnes.
